# EUROPEAN PATENT APPLICATION

(11) **EP 4 761 055 A1**
(43) Date of publication of application: **17.06.2026**
(21) Application number: 25220768.3
(22) Date of filing: 04.12.2025
(51) Int. Cl.: H02J 7/54, H02J 7/82

(54) **BATTERY MANAGEMENT APPARATUS, METHOD OF BALANCING BATTERY CELLS WITH BATTERY MANAGEMENT APPARATUS, AND BATTERY PACK INCLUDING BATTERY MANAGEMENT APPARATUS**

(30) Priority: 10.12.2024 KR 20240182850
(71) Applicant: SAMSUNG SDI CO., LTD., Yongin-si, Gyeonggi-do 17084 (KR)
(72) Inventor: CHO, Young Shin, 16678 Suwon-si (KR); PARK, Jong Sam, 16678 Suwon-si (KR); KANG, Kyung Do, 16678 Suwon-si (KR)
(74) Representative: Marks & Clerk LLP

(57) **Abstract**

According to some aspects of the present disclosure, a battery management apparatus may include a balancing circuit including a plurality of balancing switches, each of which may be provided on a discharge path, along which one of a plurality of battery cells may be discharged and a processor configured to set a balancing target voltage of each battery cell of the plurality of battery cells based on a high voltage exposure history of each respective battery cell of the plurality of battery cells when balancing of the plurality of battery cells may be required, and configured to perform the balancing of the plurality of battery cells by controlling balancing switches corresponding to each battery cell so that a cell voltage of each battery cell becomes the balancing target voltage of each respective battery cell.

## Description

### BACKGROUND

### 1. Field of the Invention

The present disclosure relates to a battery management apparatus, method of balancing battery cells with a battery management apparatus, and a battery pack including a battery management apparatus.

### 2. Discussion of Related Art

A battery pack includes battery cells and peripheral circuits including charge/discharge circuits. The peripheral circuits are manufactured on printed circuit boards and then are coupled to the battery cells. When an external power source is connected to an external terminal of a battery pack, battery cells are charged, and, when a load is connected to the external terminal, the battery cells are discharged. The charge/discharge circuit controls the charging/discharging of the battery cells between the external terminal and the battery cells. Generally, a plurality of battery cells is connected in series or in parallel depending on a consumption power of the load.

Battery cells that constitute a battery pack have capacity deviations due to various reasons in the manufacturing process, and, as the battery cells are repeatedly charged or discharged, a deviation between cell voltages of the battery cells occurs. Accordingly, some of the battery cells may be over-charged during charging, or some of the battery cells may be over-discharged during discharging. As some of the battery cells are over-charged or over-discharged, the capacity of the battery pack is decreased, the battery pack is degraded rapidly, and the lifetime of the battery pack is shortened.

In order to eliminate capacity and voltage deviations between battery cells, a cell balancing function is applied to a battery management system (BMS) of a battery pack, and the BMS performs discharge on the battery cells with relatively large capacity and high voltage so that the capacity and voltage of each battery cell are distributed within a set range.

However, conventional cell balancing has a problem in that, when a cell voltage remains unbalanced, there is a risk that battery cells with relatively high voltage may be over-charged, and the battery cells with relatively high voltage experience higher voltage stresses than other battery cells, which causes rapid degradation of the battery cell.

The above information disclosed in this Background section is for enhancement of understanding of the background of the present disclosure, and therefore, it may contain information that does not constitute related (or prior) art.

### SUMMARY OF THE INVENTION

The present invention is directed to providing a battery management apparatus capable of suppressing a degradation deviation between cells caused by long-term voltage differences by rearranging battery cells, that are exposed to relatively high voltages, to lower voltage ranks through balancing how much the battery cell is exposed to high voltages. The present invention is also directed to a method of balancing a battery cell with a battery management apparatus, and a battery pack including a battery management apparatus.

However, objectives that the present invention intends to achieve are not limited to the above-described objectives, and other objectives that are not described may be clearly understood by those skilled in the art from the following description.

According to some aspects of the present disclosure, a battery management apparatus may include a balancing circuit including a plurality of balancing switches, each of which may be provided on a discharge path, along which one of a plurality of battery cells may be discharged and a processor configured to set a balancing target voltage of each battery cell of the plurality of battery cells based on a high voltage exposure history of each respective battery cell of the plurality of battery cells when balancing of the plurality of battery cells may be required, and configured to perform the balancing of the plurality of battery cells by controlling balancing switches corresponding to each battery cell so that a cell voltage of each battery cell becomes the balancing target voltage of each respective battery cell.

In some embodiments, the processor may be configured to calculate a cell voltage difference between a maximum voltage and a minimum voltage among cell voltages of the plurality of battery cells. The processor may be configured to determine that the balancing of the plurality of battery cells may be required when the cell voltage difference exceeds a preset first threshold value.

In some embodiments, the high voltage exposure history may include at least one of a cell voltage level of each battery cell, an accumulated voltage difference value of each battery cell, and an accumulated balancing value of each battery cell.

In some embodiments, the processor may be configured to generate a first pre-balancing voltage ranking by sorting the plurality of battery cells in descending order of cell voltage levels of each battery cell at a balancing start time point, set a first post-balancing voltage ranking in a reverse order of the first pre-balancing voltage ranking, set a cell voltage of a highest ranked battery cell in the first post-balancing voltage ranking to be a reference voltage, which may be a maximum voltage, set a balancing target voltage of a lowest ranked battery cell in the first post-balancing voltage ranking to be a minimum voltage, and set balancing target voltages of remaining battery cells to be a voltage between the reference voltage and the minimum voltage based on the first post-balancing voltage ranking.

In some embodiments, the processor may be configured to generate a second pre-balancing voltage ranking by sorting the plurality of battery cells in descending order of accumulated voltage difference values of each battery cell at a balancing start time point, set a second post-balancing voltage ranking in a reverse order of the second pre-balancing voltage ranking, set a cell voltage of a highest ranked battery cell in the second post-balancing voltage ranking to be a reference voltage, which may be a maximum voltage, set a balancing target voltage of a lowest ranked battery cell in the second post-balancing voltage ranking to be a minimum voltage, and set balancing target voltages of remaining battery cells to be a voltage between the reference voltage and the minimum voltage based on the second post-balancing voltage ranking.

In some embodiments, the accumulated voltage difference value of each battery cell may be a value obtained by accumulating a voltage difference between the cell voltage of each battery cell and an average voltage for each battery cell when cell voltages of all of the plurality of battery cells may be greater than or equal to a third threshold value in a standby state without charging or discharging each respective battery cell.

In some embodiments, the processor may be configured to generate a third pre-balancing voltage ranking by sorting the plurality of battery cells in descending order of accumulated balancing values of each battery cell at a balancing start time point, set a third post-balancing voltage ranking in a reverse order of the third pre-balancing voltage ranking, set a cell voltage of a highest ranked battery cell in a third post-balancing voltage ranking to be a reference voltage, which may be a maximum voltage, set a balancing target voltage of a lowest ranked battery cell in the third post-balancing voltage ranking to be a minimum voltage, and set the balancing target voltages of remaining battery cells to be a voltage between the reference voltage and the minimum voltage based on the third post-balancing voltage ranking.

In some embodiments, the accumulated balancing value of each battery cell may be a value obtained by accumulating at least one of a balancing time and a balancing capacity of each battery cell.

In some embodiments, the minimum voltage may be a difference between the reference voltage and a second threshold value, which may be set to end balancing.

In some embodiments, the processor may be configured to turn on a balancing switch corresponding to each respective battery cell so that each respective battery cell may be discharged through a corresponding balancing resistor, and the processor may be configured to turn off the balancing switch corresponding to each respective battery cell so that a discharge of each corresponding battery cell may be stopped when a battery cell may have a cell voltage equal to the balancing target voltage.

According to some aspects of the present disclosure, a battery cell balancing method of a battery management apparatus may include determining, by a processor, whether balancing of a plurality of battery cells may be required based on cell voltages of the plurality of battery cells; after determining that the balancing of the plurality of battery cells may be required, setting, by the processor, a balancing target voltage of each battery cell based on a high voltage exposure history of each battery cell; and performing, by the processor, the balancing of the plurality of battery cells by controlling balancing switches corresponding to each battery cell of the plurality of battery cells so that a cell voltage of each respective battery cell becomes the balancing target voltage of each respective battery cell.

In some embodiments, when determining whether the balancing of the plurality of battery cells may be required, the processor calculates a cell voltage difference between a maximum voltage and a minimum voltage among cell voltages of the plurality of battery cells, and, when the cell voltage difference exceeds a preset first threshold value, the processor determines that the balancing of the plurality of battery cells may be required.

In some embodiments, the method may further include configuring the high voltage exposure history to may include at least one of a cell voltage level of each battery cell, an accumulated voltage difference value of each battery cell, and an accumulated balancing value of each battery cell.

In some embodiments, the method further includes, when setting the balancing target voltage of each battery cell, using the processor to generate a first pre-balancing voltage ranking by sorting the plurality of battery cells in descending order of cell voltage levels of each battery cell at a balancing start time point, set a first post-balancing voltage ranking in a reverse order of the first pre-balancing voltage ranking, set a cell voltage of a highest ranked battery cell in the first post-balancing voltage ranking to be a reference voltage, which may be a maximum voltage, set a balancing target voltage of a lowest ranked battery cell in the first post-balancing voltage ranking to be a minimum voltage, and set balancing target voltages of remaining battery cells to be a voltage between the reference voltage and the minimum voltage based on the first post-balancing voltage ranking.

In some embodiments, the method further includes, when setting the balancing target voltage of each battery cell, using the processor to generate a second pre-balancing voltage ranking by sorting the plurality of battery cells in descending order of accumulated voltage difference values of each battery cell at a balancing start time point, set a second post-balancing voltage ranking in a reverse order of the second pre-balancing voltage ranking, set a cell voltage of a highest ranked battery cell in the second post-balancing voltage ranking to be a reference voltage, which may be a maximum voltage, set a balancing target voltage of a lowest ranked battery cell in the second post-balancing voltage ranking to be a minimum voltage, and set balancing target voltages of remaining battery cells to be a voltage between the reference voltage and the minimum voltage based on the second post-balancing voltage ranking.

In some embodiments, the method may further include accumulating a voltage difference between the cell voltage of each battery cell and an average voltage for each battery cell when cell voltages of all of the plurality of battery cells may be greater than or equal to a second threshold value in a standby state without charging or discharging the battery cell in order to obtain the accumulated voltage difference value of each battery cell.

In some embodiments, the method further includes, when setting the balancing target voltage of each battery cell, using the processor to generate a third pre-balancing voltage ranking by sorting the plurality of battery cells in descending order of accumulated balancing values of each battery cell at a balancing start time point, set a third post-balancing voltage ranking in a reverse order of the third pre-balancing voltage ranking, set a cell voltage of a highest ranked battery cell in a third post-balancing voltage ranking to be a reference voltage, which may be a maximum voltage, set a balancing target voltage of a lowest ranked battery cell in the third post-balancing voltage ranking to be a minimum voltage, and set balancing target voltages of remaining battery cells to be a voltage between the reference voltage and the minimum voltage based on the third post-balancing voltage ranking.

In some embodiments, the method may further include accumulating at least one of a balancing time and balancing capacity of each battery cell to obtain the accumulated balancing value of each battery cell.

In some embodiments, the method may further include determining the minimum voltage of a battery cell by taking a difference between the reference voltage of the battery cell and a second threshold value of the battery cell, which may be set as a value to end balancing.

According to some aspects of the present disclosure, a battery pack may include a plurality of battery cells; a balancing circuit including a plurality of balancing switches, each of which may be provided on a discharge path, along which one of the plurality of battery cells may be discharged; a voltage measure configured to measure a cell voltage of each battery cell of the plurality of battery cells; and a processor configured to determine whether balancing of the plurality of battery cells may be required based on cell voltages of the plurality of battery cells, when the processor determines that the balancing of the plurality of battery cells may be required, to set a balancing target voltage of each battery cell of the plurality of battery cells based on a high voltage exposure history of each respective battery cell of the plurality of battery cells, and to perform the balancing of the plurality of battery cells by controlling balancing switches corresponding to each respective battery cell so that a cell voltage of each respective battery cell becomes the balancing target voltage of each respective battery cell.

However, effects and aspects that can be achieved through the present invention are not limited to the above-descriptions, and other effects and aspects that are not described above may be clearly understood by those skilled in the art from the drawings and the detailed description below.

At least some of the above and other features of the invention are set out in the claims.

### BRIEF DESCRIPTION OF THE DRAWINGS

The following drawings attached to this specification illustrate embodiments of the present disclosure, and further describe aspects and features of the present disclosure together with the detailed description of the present disclosure. The present disclosure should not be construed as being limited to the drawings.
FIG. 1 is a block diagram schematically illustrating a configuration of a battery management apparatus according to some embodiments of the present disclosure.
FIG. 2 is a circuit diagram of a battery management apparatus according to some embodiments of the present disclosure.
FIGS. 3A to 3C are example diagrams for describing conventional cell balancing management apparatuses according to some embodiments of the present disclosure.
FIGS. 4A and 4B are example diagrams illustrating an operation of setting a post-balancing voltage ranking on the basis of a cell voltage level of each battery cell according to some embodiments of the present disclosure.
FIGS. 5A and 5B are example diagrams illustrating an operation of setting a post-balancing voltage ranking on the basis of an accumulated voltage difference value of each battery cell according to some embodiments of the present disclosure.
FIG. 6 is a flowchart of a battery cell balancing method according to some embodiments of the present disclosure.
FIG. 7 is a flowchart of a battery cell balancing method based on a cell voltage level according to some embodiments of the present disclosure.
FIG. 8 is a flowchart of a battery cell balancing method based on an accumulated voltage difference value according to some embodiments of the present disclosure.
FIG. 9 is a flowchart of a battery cell balancing method based on an accumulated balancing value according to some embodiments of the present disclosure.

### DETAILED DESCRIPTION OF EXAMPLE EMBODIMENTS

Hereinafter, embodiments of the present disclosure will be described, in detail, with reference to the accompanying drawings. The terms or words used in this specification and the claims should not be construed as being limited to the usual or dictionary meanings thereof and should be interpreted in a manner consistent with descriptions of the present disclosure.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C," "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value greater than or equal to 1.0 and a maximum value less than or equal to 10.0, such as, for example, 2.4 to 7.6. Any maximum numerical limitation recited in this disclosure is intended to include all lower numerical limitations subsumed in the maximum numerical limitation, and any minimum numerical limitation recited in this specification is intended to include all higher numerical limitations subsumed in the minimum numerical limitation. Accordingly, Applicant reserves the right to amend this specification, including the claims, to expressly recite any sub-range subsumed within the ranges expressly recited herein.

References to two compared elements, features, etc. as being "the same" may mean that they are "substantially the same." Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

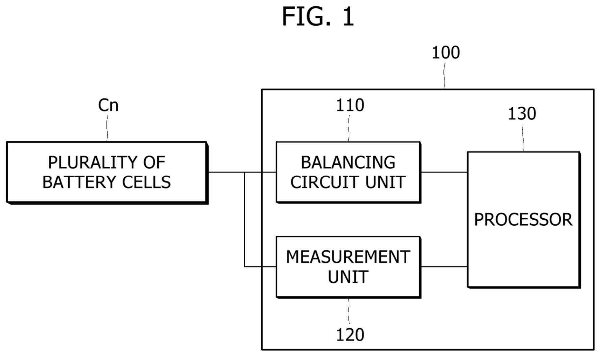

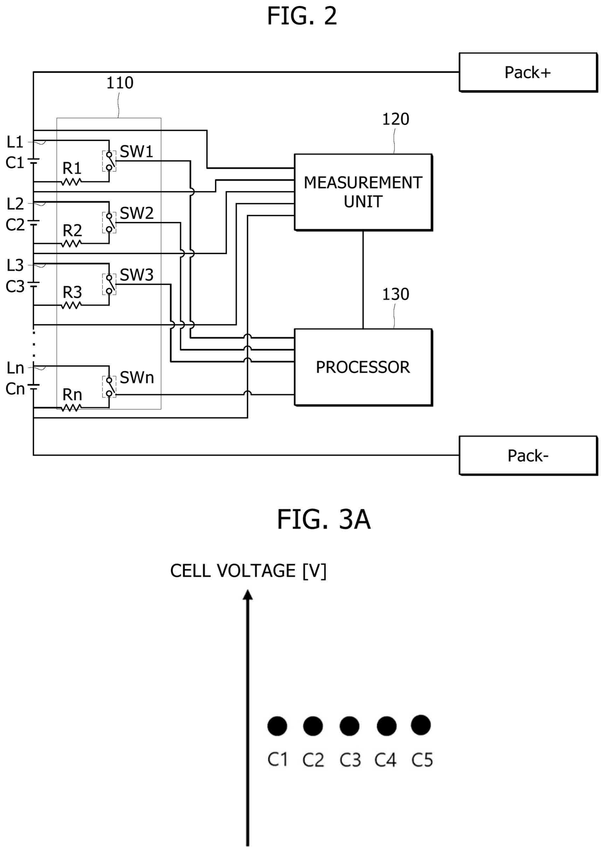

FIG. 1 is a block diagram schematically illustrating a configuration of a battery management apparatus according to some embodiments of the present disclosure. FIG. 2 is a circuit diagram of a battery management apparatus according to some embodiments of the present disclosure.

Referring to FIGS. 1 and 2, a battery management apparatus 100 according to some embodiments of the present invention may be included in a battery pack including a plurality of battery cells C1, C2, ..., and Cn (hereinafter referred to as "Cn") and may discharge some of the plurality of battery cells Cn so as to reduce an imbalance between cell voltages of the plurality of battery cells Cn.

To this end, the battery management apparatus 100 according to some embodiments may include a balancing circuit 110, a voltage measure 120 (e.g. a voltage measurement unit 120), and a processor 130. The balancing circuit 110, the voltage measure 120, and the processor 130 may constitute a battery management system (BMS), and the plurality of battery cells Cn and the BMS may constitute a battery pack.

The balancing circuit 110 may include a plurality of balancing resistors R1, R2, ..., and Rn (hereinafter referred to as "R") and a plurality of balancing switches SW1, SW2, ..., and SWn (hereinafter referred to as "SW") that are provided on discharge paths L1, L2, ..., and Ln (hereinafter referred to as "L") formed when balancing of the plurality of battery cells Cn is performed.

The plurality of balancing resistors R may be electrically connected to the plurality of battery cells Cn provided in the battery pack through the plurality of discharge paths L, respectively.

The plurality of balancing resistors R may be connected to the plurality of battery cells Cn provided in the battery pack in series to discharge each of the plurality of battery cells Cn through the plurality of discharge paths L.

The plurality of balancing switches SW may be provided in the plurality of discharge paths L to allow the plurality of balancing resistors R to be or not to be electrically connected to the plurality of battery cells Cn.

The plurality of balancing switches SW may be controlled to be in an on state or an off state by the processor 130 to allow the plurality of balancing resistors R to be or not to be electrically connected to the plurality of battery cells Cn.

When the plurality of balancing switches SW are controlled to be in an on state, the plurality of balancing resistors R and the plurality of battery cells Cn may be electrically connected. Accordingly, the cell voltages of the plurality of battery cells Cn may be applied to the plurality of balancing resistors R so that the plurality of battery cells Cn may be discharged.

When the plurality of balancing switches SW are controlled to be in an off state, the plurality of balancing resistors R and the plurality of battery cells Cn may not be electrically connected. Accordingly, each of the cell voltages of the plurality of battery cells Cn may not be applied to each of the plurality of balancing resistors R so that the plurality of battery cells Cn may not be discharged.

On/off operations of the plurality of balancing switches SW may be individually controlled by the processor 130. The plurality of balancing switches SW may be in different operating states.

For example, a case in which the battery management apparatus 100 is included in a battery pack including five battery cells C1, C2, C3, C4, and C5 and performs balancing of cell voltages of the five battery cells C1, C2, C3, C4, and C5 will be described. In this case, when a first balancing switch SW1 and a second balancing switch SW2 are turned on by the processor 130 and a third balancing switch SW3 to a fifth balancing switch SW5 are turned off, a balancing current may flow through a first balancing resistor R1 and a second balancing resistor R2 that are connected to both ends of a first battery cell C1 corresponding to the first balancing switch SW1 and both ends of a second battery cell C2 corresponding to the second balancing switch SW2 so that the discharge of the first battery cell C1 and the second battery cell C2 may be performed. In addition, flows of a balancing current of each of a third battery cell C3 corresponding to the third balancing switch SW3, a fourth battery cell C4 corresponding to the fourth balancing switch SW4, and a fifth battery cell C5 corresponding to the fifth balancing switch SW5 may be blocked.

The plurality of balancing switches SW may be implemented with relays or field-effect transistors (FETs).

In FIGS. 1 and 2, although an embodiment of a structure in which the balancing circuit 110 is circuit-wise separated from the processor 130 is illustrated, an embodiment in which the balancing circuit 110 is included (integrated) in the processor 130 may be provided.

The voltage measure 120 may measure a cell voltage used when balancing of the plurality of battery cells Cn is performed and may provide the cell voltage to the processor 130.

The voltage measure 120 may measure a cell voltage of each of the plurality of battery cells Cn. The voltage measure 120 may measure the cell voltage of each battery cell Cn by measuring a voltage at both ends of each of the plurality of battery cells Cn. The voltage measure 120 may measure the cell voltage of each battery cell Cn in various forms, but the present invention is not limited by such a voltage measurement method.

The voltage measure 120 may measure a cell current flowing into or from the plurality of battery cells Cn and may provide the cell current to the processor 130.

Accordingly, the voltage measure 120 may include a voltage sensor configured to measure cell voltages of the plurality of battery cells Cn. Further, the voltage measure 120 may further include a current sensor configured to measure cell currents of the plurality of battery cells Cn.

The processor 130 controls balancing of the battery cells Cn and may be implemented as a central processor (CPU) or a system on chip (SoC). The processor 130 may control a plurality of hardware or software components connected to the processor 130 by driving an operating system or application, and the processor 130 may perform various types of data processing and operations. In particular, in some embodiments, the processor 130 may correspond to an analog front end (AFE) integrated circuit (IC) of a BMS that monitors a state of a battery, such as monitoring voltage, current, temperature, and state of charge (SOC) of the battery cells Cn, and the processor 130 may control balancing of the battery cells Cn on the basis of a result of the monitoring.

When balancing of the plurality of battery cells Cn is required, the processor 130 may set a balancing target voltage of each battery cell Cn on the basis of a high voltage exposure history of each battery cell Cn, and the processor 130 may perform balancing of the plurality of battery cells Cn by controlling a corresponding balancing switch SW so that the cell voltage of each battery cell Cn becomes the balancing target voltage.

The processor 130 may calculate a cell voltage difference representing a difference between a maximum voltage and a minimum voltage among the cell voltages of the plurality of battery cells Cn measured through the voltage measure 120, and the processor 130 may determine whether balancing of the plurality of battery cells Cn is required on the basis of the cell voltage difference. The processor 130 may compare the cell voltage difference with a preset first threshold value, and, when the cell voltage difference exceeds the first threshold value, the processor 130 may determine that balancing of the plurality of battery cells Cn is required. The first threshold value is a preset value for starting cell balancing and may be changed.

Meanwhile, a general cell balancing method is to perform cell balancing in the case of a battery cell whose cell voltage difference exceeds the first threshold value on the basis of a battery cell having a minimum voltage and to repeat a process of performing cell balancing to reduce a voltage difference between a battery cell having a maximum voltage and a battery cell having a minimum voltage to be less than or equal to a second threshold value. The second threshold value is a preset value to end balancing and may be a difference between the maximum voltage and the minimum voltage.

FIGS. 3A to 3C are example diagrams for describing conventional cell balancing management apparatuses according to some embodiments of the present disclosure.

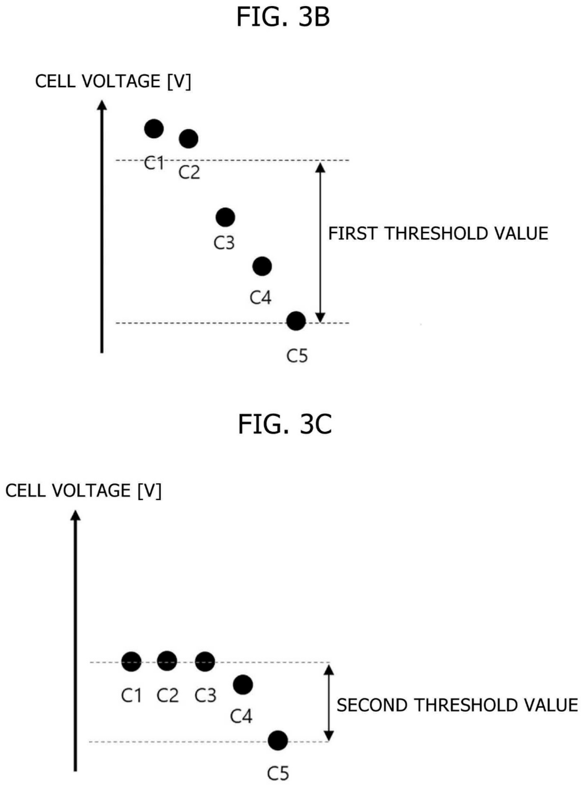

As illustrated in FIG. 3A, the first battery cell C1 to the fifth battery cell C5 having the same cell voltage have a deviation between their cell voltages while performing charging or discharging. As illustrated in FIG. 3B, when a difference between the first battery cell C1 and the second battery cell C2 exceeds the first threshold value on the basis of the fifth battery cell C5 having the minimum voltage, the processor 130 performs cell balancing. The processor 130 performs balancing on the third battery cell C3 as well as the first battery cell C1 and the second battery cell C2 in order to satisfy the second threshold value, as illustrated in FIG. 3C.

Battery cell balancing as described above causes the battery cell having the maximum voltage to experience a higher voltage stress than other battery cells. Thus, a battery cell having a maximum voltage is degraded relatively faster than battery cells not having the maximum voltage.

Conventional cell balancing methods cause a long-term difference in high-voltage accumulated stress between battery cells that are targets of cell balancing (battery cells with high voltage) and battery cells that are not targets of cell balancing (battery cells with low voltage), which can cause a difference in degradation between the battery cells. It is preferred to suppress a degradation deviation between the battery cells caused by the long-term voltage difference. In order to suppress the degradation deviation between the battery cells, battery cells exposed to a high voltage should be configured to have a relatively low voltage.

Accordingly, the processor 130 may be configured to suppress a degradation deviation between cells caused by long-term voltage differences by rearranging the battery cells exposed to high voltages to lower voltage ranks through balancing.

To this end, the processor 130 may set a balancing target voltage of each battery cell Cn on the basis of a high voltage exposure history of each battery cell Cn. The high voltage exposure history may include a cell voltage level of each battery cell, an accumulated voltage difference value of each battery cell, an accumulated balancing value of each battery cell, etc., at a balancing start time point.

Therefore, the processor 130 may set the balancing target voltage so that a battery cell having the largest cell voltage before balancing has the smallest cell voltage after balancing and may set the balancing target voltage so that a battery cell having the smallest cell voltage before balancing has the largest cell voltage after balancing. Further, the processor 130 may set the balancing target voltage so that a battery cell having the largest accumulated voltage difference value of each battery cell before balancing has the smallest cell voltage after balancing, and the processor 130 may set the balancing target voltage so that a battery cell having the smallest accumulated voltage difference value of each battery cell before balancing has the largest cell voltage after balancing. Further, the processor 130 may set the balancing target voltage so that a battery cell having the largest accumulated balancing value before balancing has the smallest cell voltage after balancing and may set the balancing target voltage so that a battery cell having the smallest accumulated balancing value before balancing has the largest cell voltage after balancing.

Specifically, the processor 130 may set voltage rankings after balancing on the basis of the high voltage exposure history of the battery cells Cn. The voltage rankings after balancing may be cell voltage level rankings of the battery cells Cn after balancing.

The processor 130 may generate a first pre-balancing voltage ranking by sorting the battery cells Cn in descending order of the cell voltage levels on the basis of the cell voltage level of each battery cell at the balancing start time point (before balancing) and may set a first post-balancing voltage ranking in a reverse order of the first pre-balancing voltage ranking. The processor 130 may generate the first pre-balancing voltage ranking by sorting the battery cells Cn in descending order of the cell voltage levels on the basis of the cell voltage level of each battery cell at the balancing start time point (before balancing) and may set the first post-balancing voltage ranking in a reverse order of the first pre-balancing voltage ranking. The first pre-balancing voltage ranking may represent a ranking of battery cells Cn sorted in descending order of the cell voltage levels at the balancing start time point (before balancing), and the first post-balancing voltage ranking may represent a ranking of battery cells Cn sorted in descending order of the cell voltage levels after balancing in a reverse order of the first pre-balancing voltage ranking.

The processor 130 may generate a second pre-balancing voltage ranking by sorting the battery cells Cn in descending order of the accumulated voltage difference values on the basis of the accumulated voltage difference value of each battery cell at the balancing start time point (before balancing) and may set a second post-balancing voltage ranking in a reverse order of the second pre-balancing voltage ranking. The processor 130 may generate the second pre-balancing voltage ranking by sorting the battery cells Cn in descending order of the accumulated voltage difference values on the basis of the accumulated voltage difference value of each battery cell at the balancing start time point (before balancing) and may set a second post-balancing voltage ranking in a reverse order of the second pre-balancing voltage ranking. The accumulated voltage difference value of each battery cell may be an accumulated value of a voltage difference between the cell voltage of each battery cell Cn and an average voltage for each battery cell when the cell voltages of all the battery cells Cn are greater than or equal to a third threshold value (e.g., 4 V) in a standby state (i.e., a standby state after full charge) without charging or discharging. Since the accumulated voltage difference value of each battery cell is larger for battery cells that have relatively higher voltage, the accumulated voltage difference value of each battery cell may be included in the high voltage exposure history, and the processor 130 may set the second post-balancing voltage ranking on the basis of the accumulated voltage difference value of each battery cell. The second pre-balancing voltage ranking may represent a ranking of battery cells Cn sorted in descending order of the accumulated voltage difference value of each battery cell at the balancing start time point (before balancing), and the second post-balancing voltage ranking may represent a ranking of battery cells Cn sorted in descending order of the cell voltage levels after balancing in a reverse order of the second pre-balancing voltage ranking. The third threshold value may be an arbitrarily set value and may be changed.

The processor 130 may generate a third pre-balancing voltage ranking by sorting the battery cells Cn in descending order of the accumulated voltage difference values on the basis of the accumulated balancing value of each battery cell at the balancing start time point (before balancing) and may set a third post-balancing voltage ranking in a reverse order of the third pre-balancing voltage ranking. The processor 130 may generate the third pre-balancing voltage ranking by sorting the battery cells Cn in descending order of the accumulated voltage difference values on the basis of the accumulated balancing value of each battery cell at the balancing start time point (before balancing) and may set a third post-balancing voltage ranking in a reverse order of the third pre-balancing voltage ranking. The accumulated balancing value of each battery cell may be an accumulated value of at least one of the balancing time and balancing capacity of each battery cell Cn for each battery cell. Since a battery cell with a relatively higher voltage has a larger accumulated balancing value, the accumulated balancing values may be included in the high voltage exposure history, and the processor 130 may set the third post-balancing voltage ranking on the basis of the accumulated balancing values. The third pre-balancing voltage ranking may represent a ranking of battery cells sorted in descending order of the accumulated balancing values at the balancing start time point (before balancing), and the third post-balancing voltage ranking may represent a ranking of battery cells sorted in descending order of the cell voltage levels after balancing in a reverse order of the third pre-balancing voltage ranking.

When the post-balancing voltage rankings are set, the processor 130 may set a balancing target voltage of each battery cell on the basis of a respective post-balancing voltage ranking. The processor 130 may set a cell voltage of the highest ranked battery cell in the post-balancing voltage ranking to be a reference voltage and may set a balancing target voltage of the lowest ranked battery cell in the post-balancing voltage ranking to be a minimum voltage. The reference voltage may be a maximum voltage, and the minimum voltage may be a difference between the reference voltage and the second threshold value (i.e., a "reference voltage-second threshold value"). The second threshold value is a preset value to end balancing and may be a difference between the maximum voltage and the minimum voltage. The processor 130 may set balancing target voltages of remaining battery cells, excluding the highest ranked battery cell and the lowest ranked battery cell, on the basis of the post-balancing voltage ranking between the reference voltage and the reference voltage-second threshold value. The processor 130 may set the balancing target voltages of the remaining battery cells at a predetermined interval between the reference voltage and the reference voltage-second threshold value. Further, the processor 130 may set the balancing target voltages of the remaining battery cells to be a voltage between the reference voltage and the reference voltage-second threshold value on the basis of the cell voltage difference (or a cell voltage difference ratio) between the battery cells before balancing.

The processor 130 may set the cell voltage of the highest ranked battery cell in the first post-balancing voltage ranking to be the reference voltage, may set the balancing target voltage of the lowest ranked battery cell in the first post-balancing voltage ranking to be the reference voltage-second threshold value, and may set the balancing target voltages of the remaining battery cells to be a voltage between the reference voltage and the reference voltage-second threshold value on the basis of the first post-balancing voltage ranking.

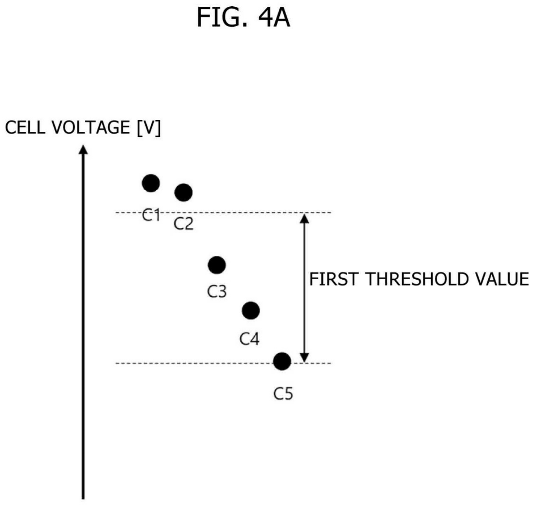

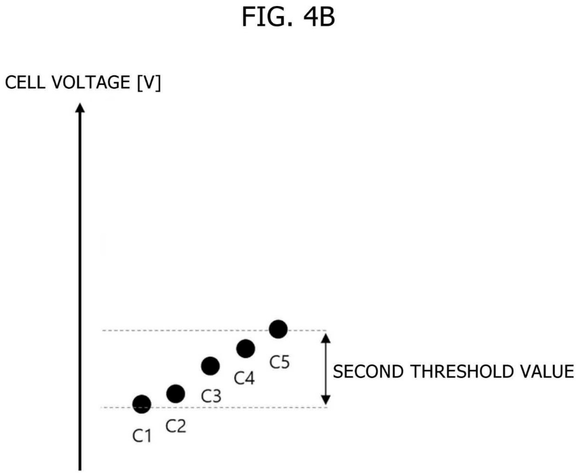

FIGS. 4A and 4B are example diagrams illustrating an operation of setting a post-balancing voltage ranking on the basis of a cell voltage level of each battery cell according to some embodiments of the present disclosure.

FIG. 4A illustrates a case in which the first pre-balancing voltage ranking is set in descending order of the cell voltage levels, i.e., in an order of the first battery cell C1, the second battery cell C2, the third battery cell C3, the fourth battery cell C4, and the fifth battery cell C5. As illustrated in FIG. 4B, the processor 130 may set the first post-balancing voltage ranking in descending order of the cell voltage levels, i.e., in an order of the fifth battery cell C5, the fourth battery cell C4, the third battery cell C3, the second battery cell C2, and the first battery cell C1. Thereafter, the processor 130 may set a cell voltage of the fifth battery cell C5, which is the highest in the first post-balancing voltage ranking, as the reference voltage and may set a balancing target voltage of the first battery cell C1, which is the lowest in the first post-balancing voltage ranking, as the reference voltage-second threshold value. The processor 130 may set the balancing target voltages so that the balancing target voltages decrease in order of the fourth battery cell C4, the third battery cell C3, and the second battery cell C2 to be a voltage between the reference voltage and the reference voltage-second threshold value.

The processor 130 may set the cell voltage of the highest ranked battery cell in the second post-balancing voltage ranking to be the reference voltage, may set the balancing target voltage of the lowest ranked battery cell in the second post-balancing voltage ranking to be the reference voltage-second threshold value, and may set the balancing target voltages of the remaining battery cells to be a voltage between the reference voltage and the reference voltage-second threshold value on the basis of the second post-balancing voltage ranking.

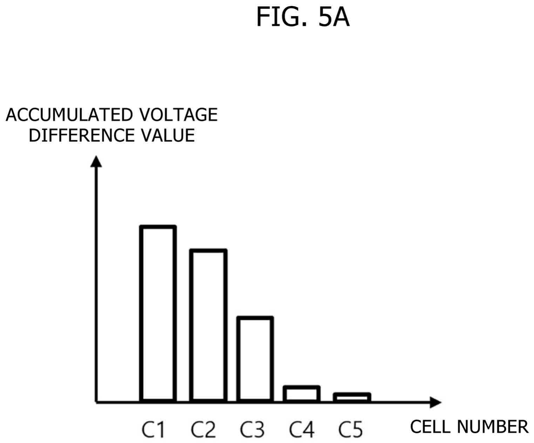

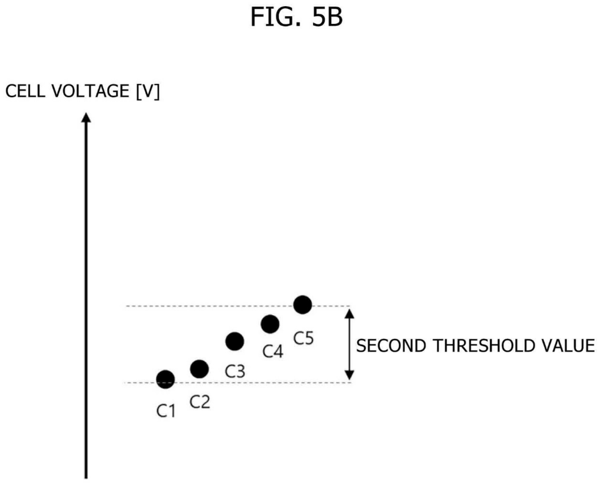

FIGS. 5A and 5B are example diagrams illustrating an operation of setting a post-balancing voltage ranking on the basis of an accumulated voltage difference value of each battery cell according to some embodiments of the present disclosure.

FIG. 5A illustrates a case in which the second pre-balancing voltage ranking is set in descending order of the accumulated voltage difference values, i.e., in an order of the first battery cell C1, the second battery cell C2, the third battery cell C3, the fourth battery cell C4, and the fifth battery cell C5. As illustrated in FIG. 5B, the processor 130 may set the second post-balancing voltage ranking in descending order of the accumulated voltage difference values, i.e., in an order of the fifth battery cell C5, the fourth battery cell C4, the third battery cell C3, the second battery cell C2, and the first battery cell C1. Thereafter, the processor 130 may set a cell voltage of the fifth battery cell C5, which is the highest in the second post-balancing voltage ranking, as the reference voltage and may set a balancing target voltage of the first battery cell C1, which is the lowest in the second post-balancing voltage ranking, as the reference voltage-second threshold value. The processor 130 may set the balancing target voltages so that the balancing target voltages decrease in order of the fourth battery cell C4, the third battery cell C3, and the second battery cell C2 to be a voltage between the reference voltage and the reference voltage-second threshold value.

The processor 130 may set the cell voltage of the highest ranked battery cell in the second post-balancing voltage ranking to be the reference voltage, may set the balancing target voltage of the lowest ranked battery cell in the second post-balancing voltage ranking to be the reference voltage-second threshold value, and may set the balancing target voltages of the remaining battery cells to be a voltage between the reference voltage and the reference voltage-second threshold value on the basis of the second post-balancing voltage ranking.

As described above, the processor 130 may set the balancing target voltage so that a battery cell having the largest cell voltage before balancing has the smallest voltage after balancing, and the processor 130 may set the balancing target voltage so that a battery cell having the smallest cell voltage before balancing has the largest voltage after balancing.

When the balancing target voltage of each battery cell is set, the processor 130 may perform balancing of the plurality of battery cells Cn by controlling a corresponding balancing switch SW so that the cell voltage of each battery cell acquires the balancing target voltage. The processor 130 may perform balancing on the remaining battery cells (hereinafter referred to as "battery cells to be balanced") in the post-balancing voltage ranking, excluding the highest ranked battery cell.

To this end, the processor 130 may control corresponding balancing switches SW so that the battery cells to be balanced are discharged through corresponding balancing resistors R. The processor 130 may simultaneously turn on the corresponding balancing switches SW so that the battery cells to be balanced are discharged through the balancing resistors R, and, in the case of a battery cell whose cell voltage is equal to the balancing target voltage among the battery cells to be balanced, the processor 130 may turn off the corresponding balancing switches SW so that the discharge of the corresponding battery cells to be balanced is stopped.

Further, the processor 130 may perform a balancing control operation on the basis of the balancing target voltages of the battery cells to be balanced. Specifically, the processor 130 may determine a balancing control order of the post-balancing voltage ranking for the battery cells to be balanced in an ascending order or descending order. Thereafter, the processor 130 may simultaneously turn on the balancing switches SW from the battery cells to be balanced with the highest ranking according to the balancing control order, and, when the cell voltage of the corresponding battery cell to be balanced becomes equal to the balancing target voltage, the processor 130 may turn off the corresponding balancing switch SW.

The processor 130 may end the cell balancing when all the battery cells to be balanced reach the balancing target voltages.

Meanwhile, in some embodiments, although the cell balancing is described as being performed by setting the balancing target voltage, the processor 130 may perform cell balancing by setting a balancing target capacity for each battery cell to be balanced. The balancing target capacity may be a value calculated based on the balancing target voltage.

Further, in some embodiments, although the battery cells Cn are described as being sorted in descending order of the cell voltage levels on the basis of the cell voltage level of each battery cell at the balancing start time point (before balancing), the processor 130 may generate a first pre-balancing voltage ranking by sorting the battery cells Cn in ascending order of the cell voltage levels on the basis of the cell voltage level of each battery cell at the balancing start time point (before balancing), and set a first post-balancing voltage ranking in a reverse order of the first pre-balancing voltage ranking. A battery cell having the largest voltage in the first post-balancing voltage ranking may be a lowest ranked battery cell, and a battery cell having the smallest voltage may be a highest ranked battery cell. Therefore, the processor 130 may set a cell voltage of the lowest ranked battery cell in the first post-balancing voltage ranking as the reference voltage and may set a balancing target voltage of the highest ranked battery cell in the first post-balancing voltage ranking as the reference voltage-second threshold value.

Further, in some embodiments, although the battery cells Cn are described as being sorted in descending order of the accumulated voltage difference values on the basis of the accumulated voltage difference value of each battery cell at the balancing start time point (before balancing), the processor 130 may generate a second pre-balancing voltage ranking by sorting the battery cells Cn in ascending order of the accumulated voltage difference values on the basis of the accumulated voltage difference value of each battery cell at the balancing start time point (before balancing), and set a second post-balancing voltage ranking in a reverse order of the second pre-balancing voltage ranking. A battery cell having the largest accumulated voltage difference value of each battery cell in the second post-balancing voltage ranking may be a lowest ranked battery cell, and a battery cell having the smallest accumulated voltage difference value of each battery cell may be a highest ranked battery cell. Therefore, the processor 130 may set a cell voltage of the lowest ranked battery cell in the second post-balancing voltage ranking as the reference voltage and may set a balancing target voltage of the highest ranked battery cell in the second post-balancing voltage ranking as the reference voltage-the second threshold value.

Further, in some embodiments, although the battery cells Cn are described as being sorted in descending order of the accumulated balancing values on the basis of the accumulated balancing value of each battery cell at the balancing start time point (before balancing), the processor 130 may generate a third pre-balancing voltage ranking by sorting the battery cells Cn in ascending order of the accumulated balancing values on the basis of the accumulated balancing value of each battery cell at the balancing start time point (before balancing), and the processor 130 may set a third post-balancing voltage ranking in a reverse order of the third pre-balancing voltage ranking. A battery cell having the largest accumulated balancing value in the third post-balancing voltage ranking may be a lowest ranked battery cell, and a battery cell having the smallest accumulated balancing value may be a highest ranked battery cell. Therefore, the processor 130 may set a cell voltage of the lowest ranked battery cell in the third post-balancing voltage ranking as the reference voltage and may set a balancing target voltage of the highest ranked battery cell in the third post-balancing voltage ranking as the reference voltage-the second threshold value.

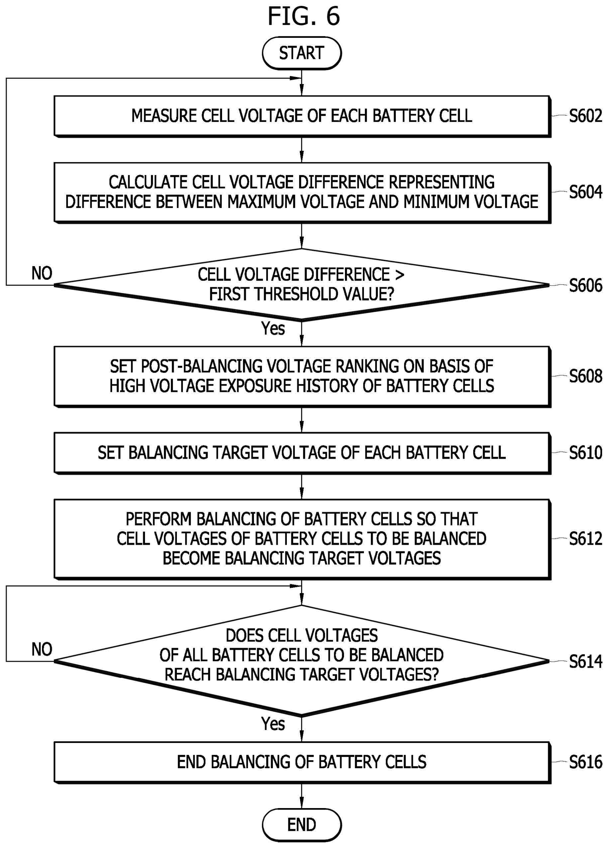

FIG. 6 is a flowchart of a battery cell balancing method according to some embodiments of the present disclosure.

The processor 130 measures a cell voltage of each battery cell Cn through the voltage measure 120 S602. The voltage measure 120 may measure the cell voltage of each battery cell Cn by measuring a voltage at both ends of each battery cell Cn.

When performing operation S602, the processor 130 calculates a cell voltage difference representing a difference between a maximum voltage and a minimum voltage of each battery cell Cn S604, and the processor 130 determines whether the cell voltage difference exceeds a first threshold value S606.

Cell balancing is to reduce the difference between the maximum voltage and the minimum voltage of the battery cells Cn, and, when the voltage difference between a battery cell having the maximum voltage and a battery cell having the minimum voltage exceeds the first threshold value, the processor 130 should perform cell balancing.

As a result of the determination in operation S606, when it is determined that the cell voltage difference exceeds the first threshold value, the processor 130 sets a post-balancing voltage ranking on the basis of a high voltage exposure history of the battery cells Cn S608. The high voltage exposure history may include a cell voltage level of each battery cell, an accumulated voltage difference value of each battery cell, an accumulated balancing value of each battery cell, etc., at a balancing start time point.

When performing operation S608, the processor 130 sets a balancing target voltage of each battery cell on the basis of the post-balancing voltage ranking S610. The processor 130 may set a cell voltage of the highest ranked battery cell (at least one of a battery cell having the largest cell voltage before balancing, a battery cell having the largest accumulated voltage difference value of each battery cell, and a battery cell having the largest accumulated balancing value) in the post-balancing voltage ranking as a reference voltage, and the processor 130 may set a balancing target voltage of the lowest ranked battery cell (at least one of a battery cell having the smallest cell voltage before balancing, a battery cell having the smallest accumulated voltage difference value of each battery cell, and a battery cell having the smallest accumulated balancing value) in the post-balancing voltage ranking as the reference voltage-second threshold value. The processor 130 may set balancing target voltages of remaining battery cells, excluding the highest ranked battery cell and the lowest ranked battery cell, on the basis of the post-balancing voltage ranking to be a voltage between the reference voltage and the reference voltage-second threshold value.

When performing operation S610, the processor 130 performs balancing of the battery cells by controlling corresponding balancing switches SW so that cell voltages of battery cells to be balanced become the balancing target voltages S612. The processor 130 may perform balancing of the battery cells by turning on the corresponding balancing switches SW so that the cell voltages of the battery cells to be balanced become the balancing target voltages. The processor 130 may perform the cell balancing by turning on corresponding balancing switches SW so that the battery cells to be balanced are discharged through corresponding balancing resistors R. Thereafter, in the case of a battery cell whose cell voltage is equal to the balancing target voltage among the battery cells to be balanced, the processor 130 may turn off the corresponding balancing switches SW so that the discharge of corresponding battery cells is stopped.

When the cell voltages of all the battery cells to be balanced reach the balancing target voltages S614, the processor 130 ends balancing of the battery cells S616.

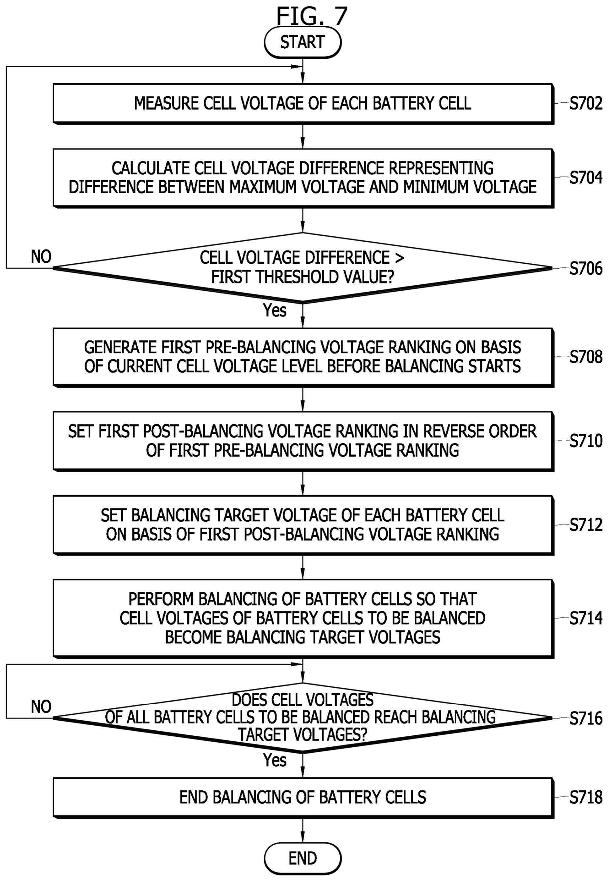

FIG. 7 is a flowchart of a battery cell balancing method based on a cell voltage level according to some embodiments of the present disclosure.

The processor 130 measures a cell voltage of each battery cell Cn through the voltage measure 120 S702.

When performing operation S702, the processor 130 calculates a cell voltage difference representing a difference between a maximum voltage and a minimum voltage of each battery cell Cn S704 and determines whether the cell voltage difference exceeds a first threshold value S706.

As a result of a determination in operation S706, when it is determined that the cell voltage difference exceeds the first threshold value, the processor 130 generates a first pre-balancing voltage ranking by sorting the battery cells Cn in descending order of cell voltage levels on the basis of a current cell voltage level (before balancing starts) S708, and the processor 130 sets a first post-balancing voltage ranking in a reverse order of the first pre-balancing voltage ranking S710. The processor 130 may set the first post-balancing voltage ranking so that a battery cell having the largest voltage before balancing has the smallest voltage after balancing and so that a battery cell having the smallest voltage before balancing has the largest voltage after balancing.

When performing operation S710, the processor 130 sets a balancing target voltage of each battery cell on the basis of the first post-balancing voltage ranking S712. The processor 130 may set a cell voltage of the highest ranked battery cell in the first post-balancing voltage ranking as a reference voltage and may set a balancing target voltage of the lowest ranked battery cell in the first post-balancing voltage ranking as the reference voltage-second threshold value. Thereafter, the processor 130 may set balancing target voltages of remaining battery cells on the basis of the first post-balancing voltage ranking to be a voltage between the reference voltage and the reference voltage-second threshold value.

When performing operation S712, the processor 130 performs balancing of the battery cells by controlling corresponding balancing switches SW so that the cell voltages of the battery cells to be balanced become the balancing target voltages S714.

By performing operation S714, when the cell voltages of all the battery cells to be balanced reach the balancing target voltages S716, the processor 130 ends balancing of the battery cells S718.

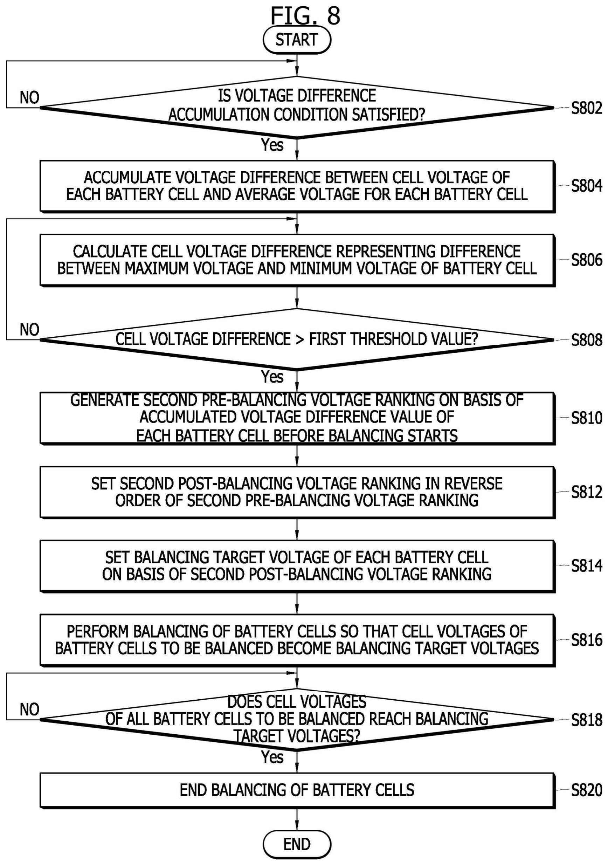

FIG. 8 is a flowchart of a battery cell balancing method based on an accumulated voltage difference value according to some embodiments of the present disclosure.

When cell voltages of all battery cells Cn satisfy a preset voltage difference accumulation condition S802, the processor 130 accumulates a voltage difference between the cell voltage of each battery cell Cn and an average voltage for each battery cell Cn S804. A voltage difference accumulation condition may mean that the cell voltages of all the battery cells Cn are greater than a third threshold value (e.g., 4 V) in a standby state (i.e., a standby state after full charge) without charging or discharging. The processor 130 may store the voltage difference between the cell voltage of each battery cell Cn and the average voltage as a histogram.

Thereafter, the processor 130 calculates a cell voltage difference representing a difference between a maximum voltage and a minimum voltage of each battery cell Cn S806 and determines whether the cell voltage difference exceeds the first threshold value S808.

As a result of the determination in operation S808, when it is determined that the cell voltage difference exceeds the first threshold value, the processor 130 generates a second pre-balancing voltage ranking by sorting the battery cells Cn in descending order of accumulated voltage difference values on the basis of a current accumulated voltage difference value of each battery cell (before balancing starts) S810 and sets a second post-balancing voltage ranking in a reverse order of the second pre-balancing voltage ranking S812. The processor 130 may set the second post-balancing voltage ranking so that a battery cell having the largest accumulated voltage difference value of each battery cell before balancing has the smallest voltage after balancing, and so that a battery cell having the smallest accumulated voltage difference value of each battery cell before balancing has the largest voltage after balancing.

When performing operation S812, the processor 130 sets a balancing target voltage of each battery cell on the basis of the second post-balancing voltage ranking S814. The processor 130 may set a cell voltage of the highest ranked battery cell in the second post-balancing voltage ranking as a reference voltage and may set a balancing target voltage of the lowest ranked battery cell in the second post-balancing voltage ranking as the reference voltage-the second threshold value. Thereafter, the processor 130 may set balancing target voltages of remaining battery cells on the basis of the second post-balancing voltage ranking to be a voltage between the reference voltage and the reference voltage-second threshold value.

When performing operation S814, the processor 130 performs balancing of the battery cells by controlling corresponding balancing switches SW so that the cell voltages of the battery cells to be balanced become the balancing target voltages S816.

By performing operation S816, when the cell voltages of all the battery cells to be balanced reach the balancing target voltages S818, the processor 130 ends balancing of the battery cells S820.

By performing balancing of the battery cells on the basis of the accumulated voltage difference value of each battery cell as described above, it is possible to prevent the phenomenon of polarization of an accumulated voltage difference value of each battery cell, thereby suppressing a degradation deviation between cells caused by the long-term voltage differences.

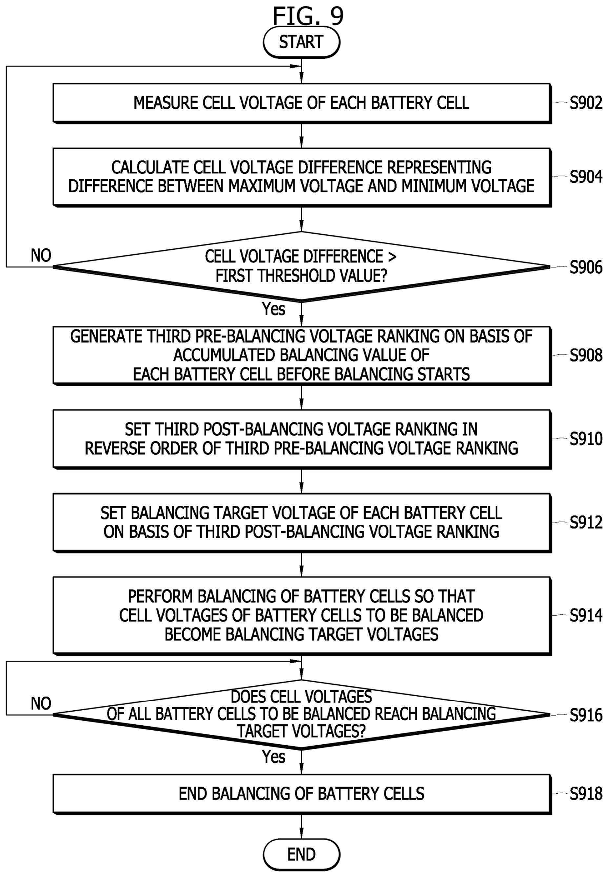

FIG. 9 is a flowchart of a battery cell balancing method based on an accumulated balancing value according to some embodiments of the present disclosure.

The processor 130 measures a cell voltage of each battery cell Cn through the voltage measure 120 S902.

When performing operation S902, the processor 130 calculates a cell voltage difference representing a difference between a maximum voltage and a minimum voltage of each battery cell Cn S904 and determines whether the cell voltage difference exceeds a first threshold value S906.

As a result of the determination in operation S906, when it is determined that the cell voltage difference exceeds the first threshold value, the processor 130 generates a third pre-balancing voltage ranking by sorting the battery cells Cn in descending order of the accumulated balancing values on the basis of a current accumulated balancing value of each battery cell (before balancing starts) S908 and sets a third post-balancing voltage ranking in a reverse order of the third pre-balancing voltage ranking S910. The processor 130 may set the third post-balancing voltage ranking so that a battery cell having the largest accumulated balancing value before balancing has the smallest voltage after balancing and so that a battery cell having the smallest accumulated balancing value before balancing has the largest voltage after balancing.

When performing operation S910, the processor 130 sets a balancing target voltage of each battery cell on the basis of the third post-balancing voltage ranking S912. The processor 130 may set a cell voltage of the highest ranked battery cell in the third post-balancing voltage ranking as the reference voltage and may set a balancing target voltage of the lowest ranked battery cell in the third post-balancing voltage ranking as the reference voltage-second threshold value. Thereafter, the processor 130 may set balancing target voltages of remaining battery cells on the basis of the third post-balancing voltage ranking to be a voltage between the reference voltage and the reference voltage-second threshold value.

When performing operation S912, the processor 130 performs balancing of the battery cells by controlling corresponding balancing switches SW so that the cell voltages of the battery cells to be balanced become the balancing target voltages S914.

By performing operation S914, when the cell voltages of all the battery cells to be balanced reach the balancing target voltages S916, the processor 130 ends balancing of the battery cells S918.

By performing balancing of the battery cells on the basis of the accumulated balancing value of each battery cell as described above, it is possible to prevent the phenomenon of polarization of the accumulated balancing value of each battery cell, thereby suppressing a degradation deviation between cells caused by the long-term voltage differences.

As described above, according to the present invention, when balancing of the battery cells is performed, by rearranging battery cells exposed to relatively high voltages to lower voltage ranks through balancing on the basis of a high voltage exposure history of the battery cells, it is possible to suppress a degradation deviation between cells caused by long-term voltage differences and increase the service lifetime of the battery pack.

According to the present invention, when balancing of battery cells is performed, by rearranging battery cells exposed to relatively high voltages to lower voltage ranks through balancing on the basis of a high voltage exposure history of the battery cells, it is possible to suppress a degradation deviation between cells caused by long-term voltage differences and to increase a service lifetime of a battery pack thereof.

The embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The apparatuses described above may be implemented by suitable hardware, software, firmware, and the like. The methods described above may be implemented on a device, such as a processor that generally refers to a processing device including a computer, a microprocessor, an integrated circuit, a programmable logic device, etc. The processor may include a communication device such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto. Various modifications and variations can be made by a person skilled in the art to which the present disclosure belongs.

## Claims

1. A battery management apparatus comprising:
a balancing circuit including a plurality of balancing switches, each of which is provided on a discharge path, along which one of a plurality of battery cells can be discharged; and
a processor configured to set a balancing target voltage of each battery cell of the plurality of battery cells based on a high voltage exposure history of each respective battery cell when balancing of the plurality of battery cells is required, and the processor being configured to perform the balancing of the plurality of battery cells by controlling balancing switches corresponding to each battery cell so that a cell voltage of each battery cell becomes the balancing target voltage of each respective battery cell.

2. The battery management apparatus of claim 1, wherein the processor is configured to calculate a cell voltage difference between a maximum voltage and a minimum voltage among cell voltages of the battery cells, and
wherein the processor is configured to determine that the balancing of the plurality of battery cells is required when the cell voltage difference exceeds a preset first threshold value.

3. The battery management apparatus of claim 1 or claim 2, wherein the high voltage exposure history includes at least one of a cell voltage level of each battery cell, an accumulated voltage difference value of each battery cell, and an accumulated balancing value of each battery cell.

4. The battery management apparatus of claim 3, wherein the processor is configured to:
generate a first pre-balancing voltage ranking by sorting the battery cells in descending order of cell voltage levels of each battery cell at a balancing start time point,
set a first post-balancing voltage ranking in a reverse order of the first pre-balancing voltage ranking,
set a cell voltage of a highest ranked battery cell in the first post-balancing voltage ranking to be a reference voltage, which is a maximum voltage,
set a balancing target voltage of a lowest ranked battery cell in the first post-balancing voltage ranking to be a minimum voltage, and
set balancing target voltages of remaining battery cells to be a voltage between the reference voltage and the minimum voltage based on the first post-balancing voltage ranking.

5. The battery management apparatus of claim 3, wherein the processor is configured to:
generate a second pre-balancing voltage ranking by sorting the battery cells in descending order of accumulated voltage difference values of each battery cell at a balancing start time point,
set a second post-balancing voltage ranking in a reverse order of the second pre-balancing voltage ranking,
set a cell voltage of a highest ranked battery cell in the second post-balancing voltage ranking to be a reference voltage, which is a maximum voltage,
set a balancing target voltage of a lowest ranked battery cell in the second post-balancing voltage ranking to be a minimum voltage, and
set balancing target voltages of remaining battery cells to be a voltage between the reference voltage and the minimum voltage based on the second post-balancing voltage ranking.

6. The battery management apparatus of claim 3, wherein the processor is configured to:
generate a third pre-balancing voltage ranking by sorting the battery cells in descending order of accumulated balancing values of each battery cell at a balancing start time point,
set a third post-balancing voltage ranking in a reverse order of the third pre-balancing voltage ranking,
set a cell voltage of a highest ranked battery cell in a third post-balancing voltage ranking to be a reference voltage, which is a maximum voltage,
set a balancing target voltage of a lowest ranked battery cell in the third post-balancing voltage ranking to be a minimum voltage, and
set the balancing target voltages of remaining battery cells to be a voltage between the reference voltage and the minimum voltage based on the third post-balancing voltage ranking.

7. The battery management apparatus of any of claims 4-6, wherein the minimum voltage is a difference between the reference voltage and a second threshold value, which is set to end balancing.

8. The battery management apparatus of any preceding claim, wherein the processor is configured to turn on a balancing switch corresponding to each respective battery cell so that each respective battery cell is discharged through a corresponding balancing resistor, and
wherein the processor is configured to turn off the balancing switch corresponding to each respective battery cell so that a discharge of each corresponding battery cell is stopped when a battery cell has a cell voltage equal to the balancing target voltage.

9. A battery cell balancing method of a battery management apparatus, the battery cell balancing method comprising:
determining, using a processor, whether balancing of a plurality of battery cells is required based on cell voltages of the battery cells;
after determining that the balancing of the plurality of battery cells is required, setting, using the processor, a balancing target voltage of each battery cell based on a high voltage exposure history of each battery cell; and
performing, using the processor, the balancing of the plurality of battery cells by controlling balancing switches corresponding to each battery cell of the plurality of battery cells so that a cell voltage of each respective battery cell becomes the balancing target voltage of each respective battery cell.

10. The battery cell balancing method of claim 9, wherein, when determining whether the balancing of the plurality of battery cells is required, the processor calculates a cell voltage difference between a maximum voltage and a minimum voltage among cell voltages of the battery cells, and
wherein, when the cell voltage difference exceeds a preset first threshold value, the processor determines that the balancing of the plurality of battery cells is required.

11. The battery cell balancing method of claim 9 or claim 10, further comprising configuring the high voltage exposure history to include at least one of a cell voltage level of each battery cell, an accumulated voltage difference value of each battery cell, and an accumulated balancing value of each battery cell.

12. The battery cell balancing method of claim 11, further comprising, when setting the balancing target voltage of each battery cell, using the processor to:
generate a first pre-balancing voltage ranking by sorting the battery cells in descending order of cell voltage levels of each battery cell at a balancing start time point,
set a first post-balancing voltage ranking in a reverse order of the first pre-balancing voltage ranking,
set a cell voltage of a highest ranked battery cell in the first post-balancing voltage ranking to be a reference voltage, which is a maximum voltage,
set a balancing target voltage of a lowest ranked battery cell in the first post-balancing voltage ranking to be a minimum voltage, and
set balancing target voltages of remaining battery cells to be a voltage between the reference voltage and the minimum voltage based on the first post-balancing voltage ranking.

13. The battery cell balancing method of claim 11, further comprising, when setting the balancing target voltage of each battery cell, using the processor to:
generate a second pre-balancing voltage ranking by sorting the battery cells in descending order of accumulated voltage difference values of each battery cell at a balancing start time point,
set a second post-balancing voltage ranking in a reverse order of the second pre-balancing voltage ranking,
set a cell voltage of a highest ranked battery cell in the second post-balancing voltage ranking to be a reference voltage, which is a maximum voltage,
set a balancing target voltage of a lowest ranked battery cell in the second post-balancing voltage ranking to be a minimum voltage, and
set balancing target voltages of remaining battery cells to be a voltage between the reference voltage and the minimum voltage based on the second post-balancing voltage ranking.

14. The battery cell balancing method of claim 11, further comprising, when setting the balancing target voltage of each battery cell, using the processor to:
generate a third pre-balancing voltage ranking by sorting the battery cells in descending order of accumulated balancing values of each battery cell at a balancing start time point,
set a third post-balancing voltage ranking in a reverse order of the third pre-balancing voltage ranking,
set a cell voltage of a highest ranked battery cell in a third post-balancing voltage ranking to be a reference voltage, which is a maximum voltage,
set a balancing target voltage of a lowest ranked battery cell in the third post-balancing voltage ranking to be a minimum voltage, and
set balancing target voltages of remaining battery cells to be a voltage between the reference voltage and the minimum voltage based on the third post-balancing voltage ranking.

15. A battery pack comprising:
a plurality of battery cells;
a balancing circuit including a plurality of balancing switches, each of which is provided on a discharge path, along which one of the plurality of battery cells can be discharged;
a voltage measure configured to measure a cell voltage of each battery cell of the plurality of battery cells; and
a processor configured to determine whether balancing of the plurality of battery cells is required based on cell voltages of the battery cells, and when the processor determines that the balancing of the plurality of battery cells is required, to set a balancing target voltage of each battery cell based on a high voltage exposure history of each respective battery cell, and to perform the balancing of the plurality of battery cells by controlling balancing switches corresponding to each respective battery cell so that a cell voltage of each respective battery cell becomes the balancing target voltage of each respective battery cell.
